# EUROPEAN PATENT APPLICATION

(11) **EP 2 028 919 A1**
(43) Date of publication of application: **25.02.2009**
(21) Application number: 08162694.7
(22) Date of filing: 20.08.2008
(51) Int. Cl.: H05K 9/00

(54) **A display apparatus having a grounding bracket**

(30) Priority: 22.08.2007 KR 20070084500
(71) Applicant: Samsung SDI Co., Ltd., Suwon-si, Gyeonggi-do (KR)
(72) Inventor: Lim, Heon-Yong, Samsung SDI co., Ltd., Suwon-si, Gyeonggi-do (KR)
(74) Representative: Grey, Ian Michael

(57) **Abstract**

A display apparatus having a ground bracket. The display apparatus includes a display panel, which displays an image, a filter, which includes an electromagnetic shielding layer and is directly attached to a first surface in which the image of the display panel is formed, and a chassis, which is disposed on the side of a second surface, which is an opposite surface of the first surface, of the display panel and supports the display panel. The ground bracket includes a conductive material, in which a first wing portion is electrically connected to the electromagnetic shielding layer of the filter, a second wing portion which is electrically connected to the chassis, and the first and second wing portions substantially face each other, and a pressing device, which is installed in the ground bracket and presses the first and second wing portions of the ground bracket in the direction the first and second wing portions are facing. Accordingly, an electromagnetic shielding performance of the filter is improved.

## Description

The present invention relates to a display apparatus, and more particularly, to a display apparatus which can improve electromagnetic shielding by enhancing grounding performance of a chassis and a filter, which are directly attached in front of the display panel.

A conventional plasma display apparatus, as an example of a display apparatus, is a flat display apparatus which includes discharge electrodes on each of the facing surfaces of a front substrate and a rear substrate. Discharge gas is filled in a discharge space sealed between the front and rear substrates, and then predetermined power is applied to each discharge electrode so as to generate ultraviolet rays in the discharge space. Accordingly, the conventional plasma display apparatus creates an image by using light emitted by exciting a phosphor substance of a phosphor layer by using the ultraviolet rays.

Such a plasma display apparatus is manufactured by combining a front panel and a rear panel after manufacturing the front and rear panels separately, combining a chassis base to the back of the panel assembly, attaching a driving circuit board, which can transmit an electric signal to the panel assembly, to the back of the chassis base, directly attaching a filter to a display panel or attaching a filter to the panel by using a filter holder, and then installing the result of the manufacturing process described above in a case.

Here, the filter is installed in order to intercept an electromagnetic wave generated from the display panel, infrared rays, neon radiation, or external light reflection. In other words, it is important to tightly ground the filter and the chassis base in order to be shielded from an electromagnetic wave and intercept infrared rays, neon radiation, or external light reflection.

The present invention provides a display apparatus, which enables a ground bracket, which grounds a chassis and a directly attached filter that is attached to the front surface of a display panel, to be stably electrically connected to each of the directly attached filter and the chassis.

According to an aspect of the present invention, there is provided a grounding bracket for a display apparatus having a display panel to display an image, a filter having an electromagnetic shielding layer attached to a first surface of the display panel, and a chassis disposed on a second surface of the display panel, said ground bracket comprising first and second facing wing portions configured to receive an edge of a display panel therebetween so that the first wing portion makes electrical contact with the electromagnetic shielding layer of the filter and the second wing portion makes electrical contact with the chassis, the bracket including means to press the first and second wing portions in a direction towards each other to improve the contact of the first and second wing portions with the electromagnetic shielding layer and the chassis, respectively.

In one embodiment, the means for pressing the first and second wing portions towards each other comprises a pressing device.

The pressing device may be a screw, the first and second wing portions having aligned holes therein to receive the screw so as to squeeze the first and second wing portions in a direction towards each other.

Preferably, the screw has a head and the hole in the second wing portion is threaded, the screw being inserted through the aligned holes in the first wing portion and threadingly engaged with the threaded hole in the second wing portion with the head engaging the first wing portion.

In an alternative embodiment, the pressing device is a rivet and the first and second wing portions having aligned holes therein to receive the rivet so as to squeeze the first and second wing portions in a direction towards each other.

In another alternative embodiment, the pressing device is a bolt and nut, the first and second wing portions having aligned holes therein to receive the bolt, the nut being threadable to the end of the bolt to squeeze the first and second wing portions in a direction towards each other as the nut is tightened.

Preferably, the nut has a head and is inserted through the aligned holes in the first and second wing portions with the head against the first wing portion, the nut threadingly coupling the bolt and engaging against the second wing portion.

In any embodiment, a conductive pad is placed between the first wing portion and the filter.

In another embodiment, the means for pressing the first and second wing portions together comprises forming the first and second wing portions from a resiliently flexible material configured such that the distance between the first and second wing portions is less than the distance between the first and second wing portions when the first and second wing portions have been elastically deformed to receive a display apparatus therebetween, so as to bias the first and second wing portions against the filter and the chassis, respectively.

According to the invention, there is also provided a display apparatus having a grounding bracket according to the invention, the display apparatus comprising a display panel which displays an image; a filter which includes an electromagnetic shielding layer and is directly attached to a first surface in which the image of the display panel is formed; a chassis, which is disposed on the side of a second surface, which is an opposite surface of the first surface, of the display panel and supports the display panel; the first wing portion of the grounding bracket being electrically connected to the electromagnetic shielding layer of the filter and the second wing portion being electrically connected to the chassis, the first and second wing portions being pressed towards each other by said means.

By using the pressing means, the first and second wing portions of the ground bracket are tightened toward each other, the first wing portion of the ground bracket is adhered closely to the chassis, and the second wing portion of the ground bracket is adhered closely to the filter, and thus a grounding performance between the electromagnetic shielding layer and the chassis improves. As a result, an electromagnetic shielding performance of the filter increases, and accordingly, the quality of the display apparatus improves.

According to another aspect of the present invention, there is provided a display apparatus including a display panel, which displays an image; a filter, which includes an electromagnetic shielding layer and is directly attached to a first surface in which the image of the display panel is formed; a chassis, which is disposed on the side of a second surface, which is an opposite surface of the first surface, of the display panel and supports the display panel; and a ground bracket, which includes a conductive material, in which a first wing portion is electrically connected to the electromagnetic shielding layer of the filter, a second wing portion is electrically connected to the chassis, and the first and second wing portions substantially face each other under an elastic force.

The first and second wing portions of the ground bracket are respectively closely adhered to the electromagnetic shielding layer of the filter and the chassis by using the ground bracket which has an elastic force. Accordingly, the first wing portion can be stably electrically connected to the chassis in a larger area, and the second wing portion can be stably electrically connected to the electromagnetic shielding layer of the filter in a larger area. An electromagnetic shielding performance of the filter is improved since the electromagnetic shielding layer is stably grounded to the chassis.

The above and other features and advantages of the present invention will become more apparent by describing in detail exemplary embodiments thereof with reference to the attached drawings in which:
FIG. 1 is an exploded perspective view illustrating a display apparatus according to an embodiment of the present invention;
FIG. 2 is an enlarged cross-sectional view illustrating an area A illustrated in FIG. 1 according to an embodiment of the present invention;
FIG. 3 is a cross-sectional view illustrating an alternative example of the embodiment illustrated in FIG. 2;
FIG. 4 is an enlarged cross-sectional view illustrating an area A illustrated in FIG. 1 according to another embodiment of the present invention;
FIG. 5 is a cross-sectional view illustrating an alternative example of the embodiment illustrated in FIG. 4;
FIG. 6 is an enlarged cross-sectional view illustrating an area A illustrated in FIG. 1 according to another embodiment of the present invention;
FIG. 7 is a cross-sectional view illustrating another alternative example of the embodiment illustrated in FIG. 2;
FIG. 8 is an enlarged cross-sectional view illustrating a part of a display apparatus according to another embodiment of the present invention;
FIG. 9A is a graph illustrating the amount of electromagnetic radiation in a conventional plasma display apparatus including a directly attached filter; and
FIG. 9B is a graph illustrating the amount of electromagnetic radiation in a plasma display apparatus according to an embodiment of the present invention.

Hereinafter, the present invention will be described more fully with reference to the accompanying drawings, in which exemplary embodiments of the invention are shown.

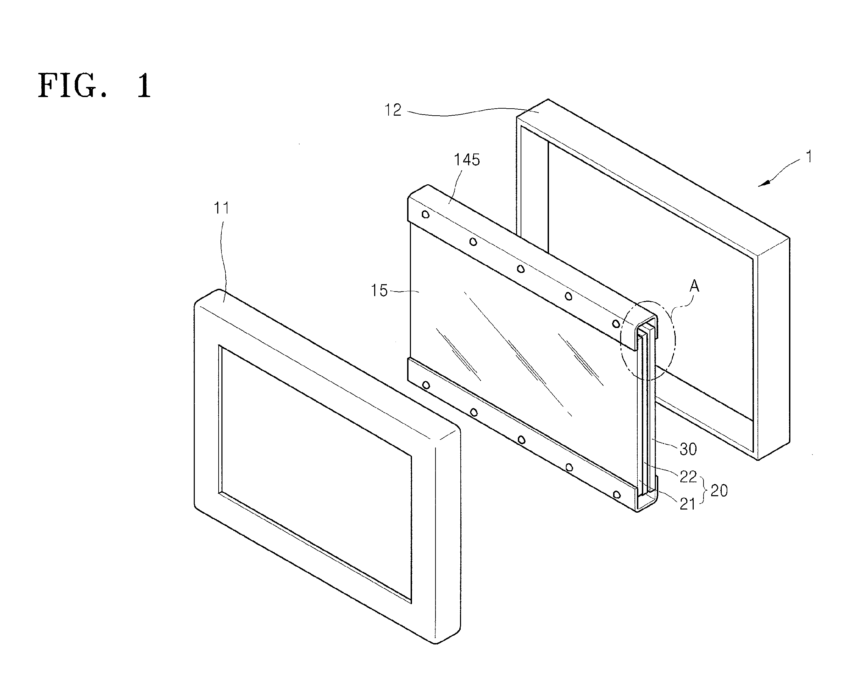

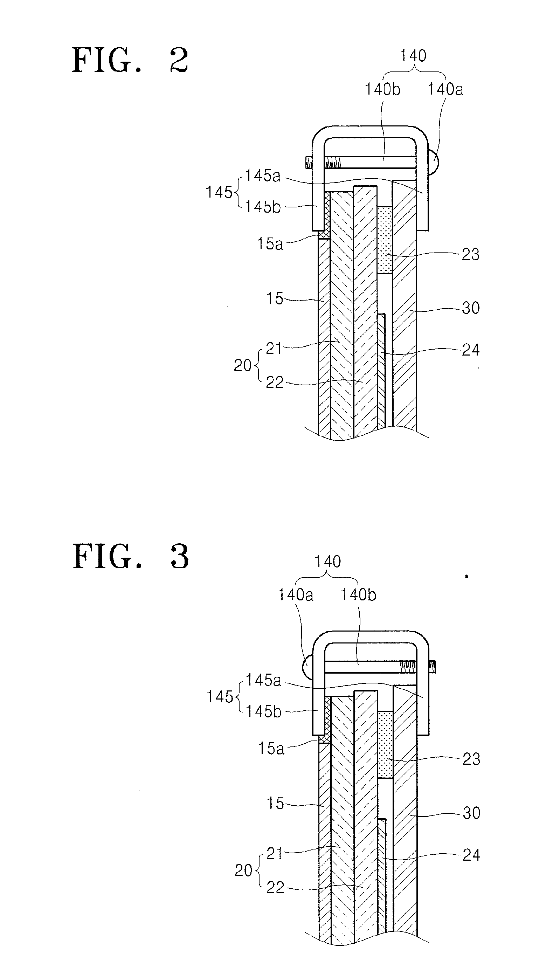

FIG. 1 is an exploded perspective view illustrating a display apparatus 1 according to an embodiment of the present invention, and FIG. 2 is an enlarged cross-sectional view illustrating an area A illustrated in FIG. 1 according to an embodiment of the present invention.

Referring to FIG. 1, the display apparatus 1 includes a display panel 20, which displays an image, a chassis 30, which supports the display panel 20, and a front case 11 and a rear case 12, which accommodate and protect the display panel 20. The display panel 20 includes a front panel 21 and a rear panel 22. The front panel 21 includes a front substrate, X and Y electrodes formed in a predetermined pattern on the front substrate, a front dielectric layer in which the X and Y electrodes are embedded, and a protective layer coated on the surface of the front dielectric layer. The rear panel 22 includes a rear substrate, an address electrode formed crossing the X and Y electrodes, a rear dielectric layer in which the address electrode is embedded, barrier ribs disposed between the front and rear substrates and restricting discharge spaces, and phosphor layers applied in the inner sides of the barrier ribs.

The chassis 30 is attached to the rear of the display panel 20. A heat dissipation member 24, consisting of at least one sheet of the heat dissipation member, is adhered to the surface of the display panel 20 between the display panel 20 and the chassis 30. The heat dissipation member 24 quickly and smoothly eliminates heat generated in the display panel 20. The display panel 20 and the chassis 30 are attached using double sided tape 23.

A driving circuit board (not shown) and other circuit boards are disposed on the rear surface of the chassis 30. The driving circuit board provides an electric signal that drives the display panel 20. Accordingly, the driving circuit board and the display panel 20 are electrically connected using signal transmission means (not shown), such as a tape carrier package (TCP) or tape automated bonding (TAB).

The chassis 30 supports such circuit boards and the display panel 20. Accordingly, the chassis 30 is formed of a material having rigidity so as to sufficiently support the circuit boards and the display panel 20. Also, the chassis 30 acts as an electrical ground to circuits in the circuit boards. Accordingly, the chassis 30 includes a conductive material. Moreover, the chassis 30 smoothly eliminates heat generated in the circuit boards and the display panel 20. Accordingly, the chassis 30 may include a material having high heat conductance. In other words, the chassis 30 is generally formed of aluminum, but the material forming the chassis 30 is not limited thereto. For example, the chassis 30 may be formed of plastic including a conductive material in some portion.

A filter 15 is directly attached to the front surface of the display panel 20. Here, the filter 15 is also called a directly attached filter, since the filter 15 is directly attached to the front surface of the display panel 20 that projects an image. The directly attached filter 15 is installed in order to intercept an electromagnetic wave generated from the display panel 20, infrared rays, neon radiation, and external light reflection.

Specifically, it is important to intercept the electromagnetic wave, and thus the directly attached filter 15 includes an electromagnetic shielding layer (not shown), wherein minute metal lines are disposed in a thin reticulatedmanner. Moreover, the directly attached filter 15 may include an infrared rays interception layer, a neon radiation interception layer, and an external light reflection interception layer. In order to intercept the electromagnetic wave, the electromagnetic shielding layer should be grounded. Accordingly, a ground bracket 145 is provided.

Referring to FIG. 2, the ground bracket 145 includes a first wing portion 145a and a second wing portion 145b that face each other, and the ground bracket 145 has a "⊏"-shaped section. However, the shape of the ground bracket 145 is not limited thereto, as long as the first and second wing portions 145a and 145b face each other, and thus the ground bracket 145 may have a "⊂"-shaped section. The surface of the first wing portion 145a is electrically connected to the rear surface of the chassis 30, and the surface of the second wing portion 145b is electrically connected to the electromagnetic shielding layer included in the directly attached filter 15. In more detail, the surface of the second wing portion 145b is electrically connected to a peripheral portion 15a. Here, the rear surface of the chassis 30, which contacts the surface of the first wing portion 145a, is formed of a material having high electric conductivity. Also, the ground bracket may be formed of a material having high conductivity, such as aluminum or steel, or may include a material having high conductivity. Accordingly, the electromagnetic shielding layer can intercept the generation of the electromagnetic wave by being grounded to the chassis 30.

However at this time, the ground between the chassis 30 and the electromagnetic shielding layer may be unstable. When the ground is unstable, an electromagnetic shielding performance remarkably decreases, and the ground between the chassis 30 and the directly attached filter 15 should be stable. Accordingly, the embodiments of the present invention include a pressing means, pressing mechanism or pressing device.

In the embodiment of FIG. 2, the pressing means, pressing mechanism or pressing device may be a screw 140. The screw 140 is formed of a main body 140b, a head 140a, and a thread. The head 140a is connected to one end of the main body 140b, and the head 140a and the main body 140b are in one body. The diameter of the head 140a is larger than the diameter of the main body 140b. The thread is formed in a partial area of the main body 140b. In more detail, the thread is formed in an end portion of the main body 140b far from the head 140a. The main body 140b is inserted into the second wing portion 145b by penetrating the first wing portion 145a until the head 140a touches the first wing portion 145a. A thread (not shown), corresponding to the thread of the main body 140b, is formed in the second wing portion 145b. Accordingly, the main body 140b of the screw 140 is combined with the second wing portion 145b of the ground bracket 145. By rotating the screw 140 in the combining direction, the head 140a presses the first wing portion 145a against the second wing portion 145b, and thus the first and second wing portions 145a and 145b are tightened in the facing direction. Accordingly, the first wing portion 145a is closely adhered to the chassis 30 and the second wing portion 145b is closely adhered to the directly attached filter 15, and thus a grounding performance between the electromagnetic shielding layer of the directly attached filter 15 and the chassis 30 improves. As a result, an electromagnetic shielding performance of the directly attached filter 15 improves, and accordingly, the quality of the display apparatus 1 improves.

Meanwhile, although not illustrated in FIG. 2, a washer may be disposed between the head 140a and the first wing portion 145a. The washer provides pre-tension between the head 140a and the first wing portion 145a in order to make sure that the screw 140 and the ground bracket 145 are tightened.

FIG. 3 is a cross-sectional view illustrating an alternative example of the embodiment illustrated in FIG. 2. FIG. 3 is different from FIG. 2, in that the proceeding direction of the screw 140 is opposite to that of the screw 140 of FIG. 2. In other words, in FIG. 3, the screw 140 is tightened to the ground bracket 145 while proceeding from the second wing portion 145b to the first wing portion 145a. The remaining description of FIG.3 is the same as that of FIG. 2.

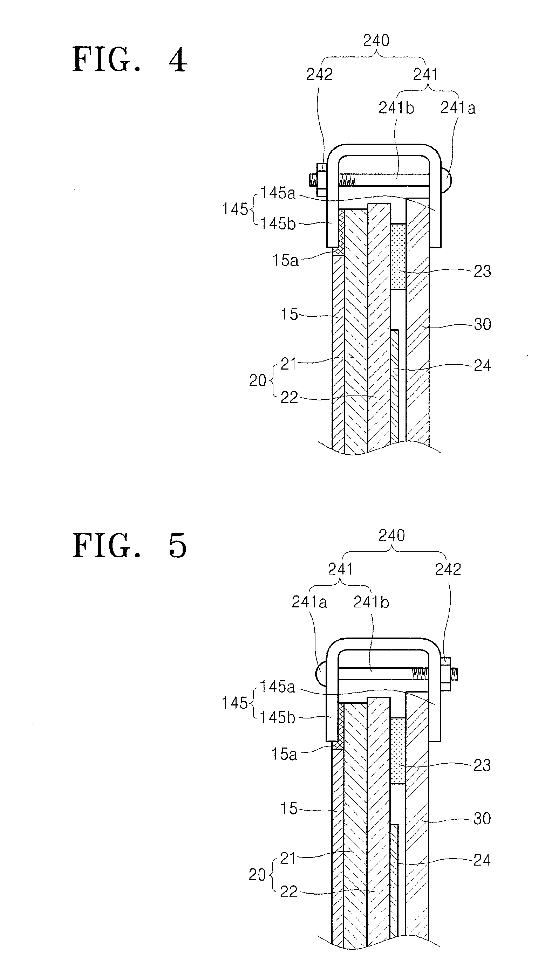

FIG. 4 is an enlarged cross-sectional view illustrating an area A illustrated in FIG. 1 according to another embodiment of the present invention. In the current embodiment, the pressing means, pressing mechanism or pressing device 240 is a bolt 241 and a nut 242. The bolt 241 is formed of a main body 241b, a head 241 a, and a thread. The head 241a is connected to one end of the main body 241b as one body and the diameter of the head 241a is smaller than the diameter of the main body 241b. A thread is formed in a partial portion of the main body 241b. In more detail, the thread is formed in one end of the main body 241b far from the head 241a. The main body 241b is inserted into a second wing portion 145b of a ground bracket 145 after penetrating a first wing portion 145a of the ground bracket 145 until the head 241a touches the first wing portion 145a. Then, the nut 242 is tightened to the thread of the main body 241b. By rotating the bolt 241 or the nut 242 in the tightening direction of the nut 242, the head 241a presses the first wing portion 145a against the second wing portion 145b, and thus the first and second wing portions 145a and 145b are tightened in the facing direction. Accordingly, the first wing portion 145a adheres closely to a chassis 30 and the second wing portion 145b adheres closely to a directly attached filter 15, and thus a grounding performance between an electromagnetic shielding layer of the directly attached filter 15 and the chassis 30 improves. Consequently, an electromagnetic shielding performance of the directly attached filter 15 improves, and thus the quality of the display apparatus 1 increases.

Meanwhile, although not illustrated in FIG. 4, the display apparatus 1 may further include a washer between the head 241a and the first wing portion 145a. The washer provides pre-tension between the head 241a and the first wing portion 145a in order to make sure that the bolt 241 and the ground bracket 145 are tightened.

FIG. 5 is a cross-sectional view illustrating an alternative example of the embodiment illustrated in FIG. 4. FIG. 5 is different from FIG. 4, in that the proceeding direction of the bolt 241 is opposite to that of the bolt 241 of FIG. 4. In other words, in FIG. 5, the bolt 241 is tightened to the nut 242 while proceeding from the second wing portion 145b to the first wing portion 145a. The remaining description of FIG. 5 is the same as the description of FIG. 4.

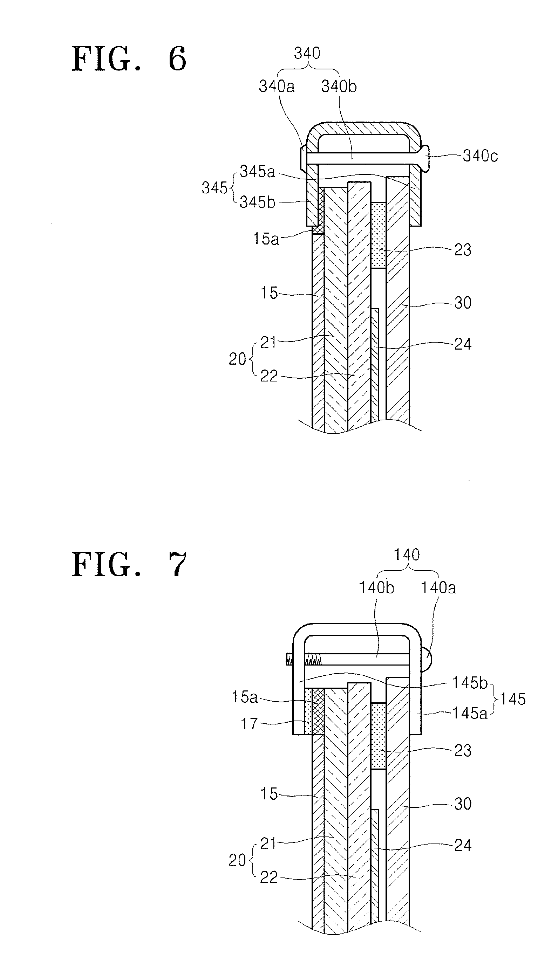

FIG. 6 is an enlarged cross-sectional view illustrating an area A illustrated in FIG. 1 according to another embodiment of the present invention. In the current embodiment, the pressing means, pressing mechanism or pressing device is a rivet 340. The rivet 340, before being tightened to a ground bracket 345, may include a main body 340b, which penetrates a first wing portion 345a and a second wing portion 345b of the ground bracket 345, and a head 340a, which touches the second wing portion 345b and presses the second wing portion 345b against the first wing portion 345a. The head 340a is connected to one end of the main body 340b as one body, and the diameter of the head 340a is larger than the diameter of the main body 340b. The main body 340b is inserted into the second wing portion 345b after penetrating the second wing portion 345b until the head 340a touches the second wing portion 345b, and then the rivet 340 is tightened against the ground bracket 345 by enlarging the diameter of an end portion 340c of the main body 340b far from the head 340a.

Since the diameter of the end portion 340c is enlarged while the first wing portion 345a and the second wing portion 345b face each other under an elastic force, the first wing portion 345a and the second wing portion 345b are tightened in the facing direction. Accordingly, the first wing portion 345a is adhered closely to a chassis 30, and the second wing portion 345b is adhered closely to a directly attached filter 15, and thus a grounding performance between an electromagnetic shielding layer of the directly attached filter 15 and the chassis 30 improves. Consequently, an electromagnetic shielding performance of the directly attached filter 15 improves, and thus the quality of the display apparatus 1 improves.

FIG. 6 illustrates the embodiment that the head 340a is disposed on the second wing portion 345b, but the location of the head 340a is not limited thereto, and the head 340a can be tightened against the ground bracket 345 while being disposed on the first wing portion 345a.

FIG. 7 is a cross-sectional view illustrating another alternative example of the embodiment illustrated in FIG. 2. The difference between the embodiment of FIG. 2 and the embodiment of FIG. 7 is that in FIG. 7, a conductive pad 17 is disposed between the peripheral portion 15a of the electromagnetic shielding layer of the directly attached filter 15 and the second wing portion 145b of the ground bracket 145. Here, the conductive pad 17 is a conductive member, which has both sides and are flat. By disposing the conductive pad 17, buffering between the ground bracket 345 and the directly attached filter 15 is improved, and thus damage that may occur when the ground bracket 345 directly touches the electromagnetic shielding layer can be prevented.

In the above embodiments, the ground brackets 145, 245, and 345 are each disposed on the top and bottom of the display panel 20, but the locations of the ground brackets 145, 245, and 345 are not limited thereto. For example, the ground brackets 145, 245, and 345 may be disposed on the left end and/or right end of the display panel 20. Also, the ground brackets 145, 245, and 345 on one side extend in one direction, and thus the number of each of the ground brackets 145, 245, and 345 is one, but the number is not limited thereto. That is, the number of each of the ground brackets 145, 245, and 345 on one side may be 2, 3, 4, or more.

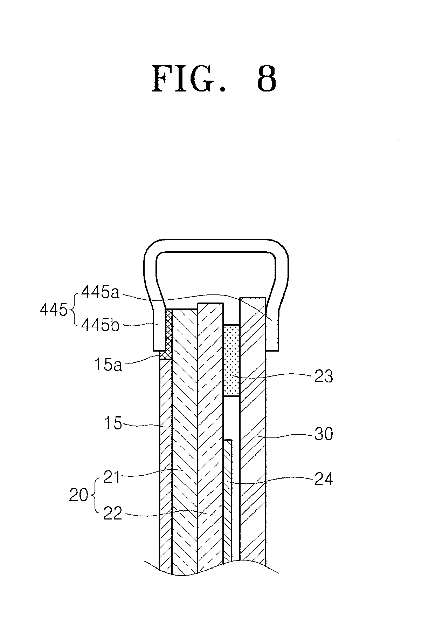

FIG. 8 is an enlarged cross-sectional view illustrating a part of a display apparatus according to another embodiment of the present invention. The difference between FIG. 1 and FIG. 8 is that the display apparatus 1 does not separately include the pressing means, pressing mechanism or pressing device, such as the screw. Alternatively in the current embodiment, an elastic force is provided so that each end portion of a first wing portion 445a and a second wing portion 445b of a ground bracket 445 face each other. In detail, a sectional form of the ground bracket 445 is '⊏' or '⊂', and an elastic force is provided to the ground bracket 445 so that the distance between an end portion of the first wing portion 445a and an end portion of the second wing portion 445a when in position on the display apparatus is greater than the distance between the end portion of the first wing portion 445a and the end portion of the second wing portion 445b at a free state.

In order to install the ground bracket 445 on a directly attached filter 15 of a display panel 20 and a chassis 30, the space between the first and second wing portions 445a and 445b are widened, and then the display panel 20 is disposed between the first wing portion 445a and the second wing portion 445b. When the first and second wing portions 445a and 445b are released to their original state, the first wing portion 445a adheres closely to the chassis 30 and the second wing portion 445b adheres closely to the directly attached filter 15 according to the elastic force between the first and second wing portions 445a and 445b. Accordingly, a grounding performance between an electromagnetic shielding layer of the directly attached filter 15 and the chassis 30 improves. Consequently, an electromagnetic shielding performance of the directly attached filter 15 improves, and thus the quality of the display apparatus 1 improves.

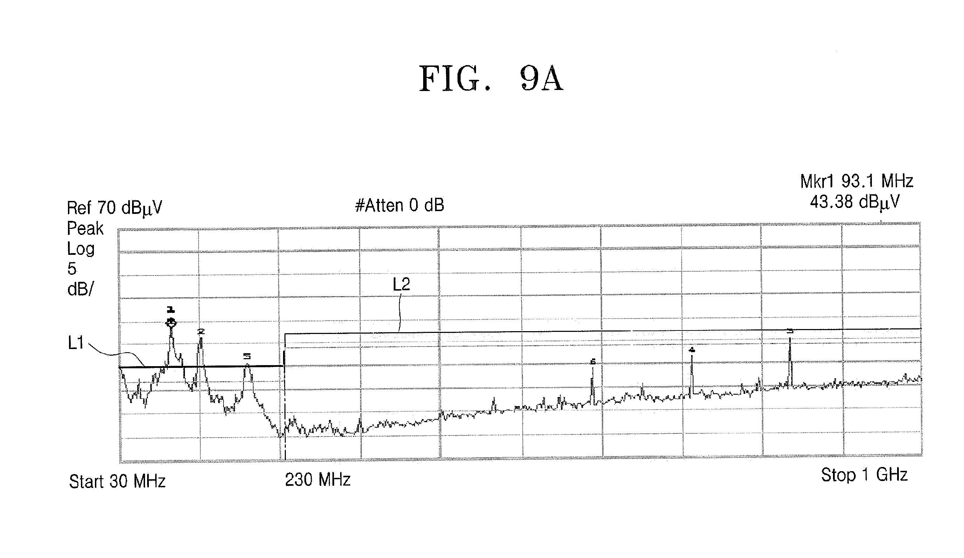

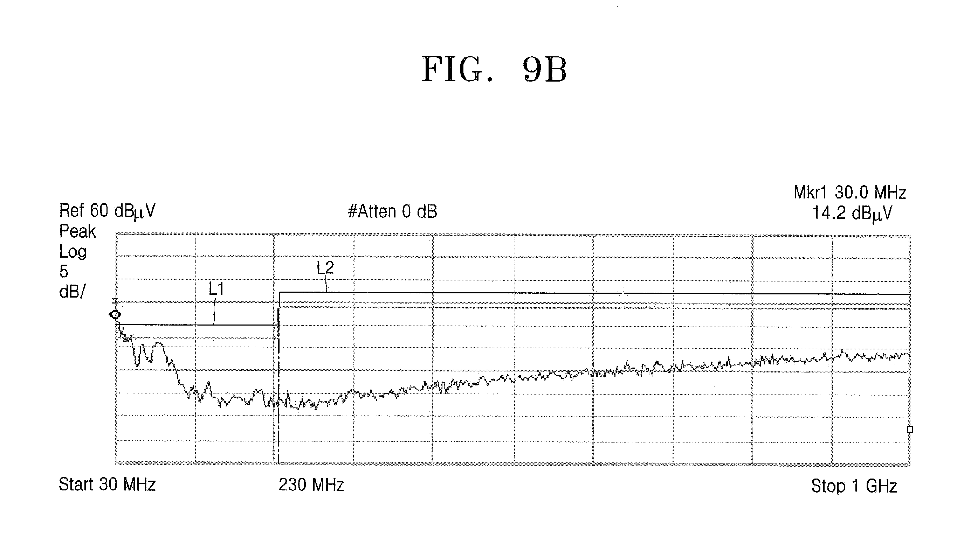

FIG. 9A is a graph illustrating the amount of electromagnetic radiation in a conventional plasma display apparatus including the directly attached filter 15 and FIG. 9B is a graph illustrating the amount of electromagnetic radiation in a plasma display apparatus according to an embodiment of the present invention. An experiment for measuring the amount of electromagnetic radiation is performed in a chamber, in which the distance between the display panel 20 and a measurement antenna is 3 m. A permissible standard of the amount of electromagnetic radiation is based on Class B (for home use) according to the Federal Communications Commission (FCC) standard of the USA. According to Class B, the amount of electromagnetic radiation should be below or equal to 40 dBµV in a section between 30 MHz to 230 MHz, and the amount of electromagnetic radiation should be below or equal to 47 dBµV in a section between 230 MHz to 1 GHz. In each section, thick solid lines L1 and L2 denote a standard value of the amount of electromagnetic radiation.

Referring to FIG. 9A, three peak values of the amount of electromagnetic radiation exceeds 40 dBµV (L1), which is the standard value in the section ranging between 30 MHz to 230 MHz, and thus the conventional plasma display apparatus is determined to be inferior for home use in a quality test. However in FIG. 9B, the amount of electromagnetic radiation does not exceed 40dBµV (L1) in any section, and thus the plasma display apparatus according to the current embodiment has superior electromagnetic shielding.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A grounding bracket for a display apparatus having a display panel to display an image, a filter having an electromagnetic shielding layer attached to a first surface of the display panel, and a chassis disposed on a second surface of the display panel, said ground bracket comprising first and second facing wing portions configured to receive an edge of a display panel therebetween so that the first wing portion makes electrical contact with the electromagnetic shielding layer of the filter and the second wing portion makes electrical contact with the chassis, the bracket including means for pressing the first and second wing portions in a direction towards each other to improve the contact of the first and second wing portions with the electromagnetic shielding layer and the chassis, respectively.

2. The ground bracket recited in claim 1, wherein the means for pressing the first and second wing portions towards each other comprises a pressing device.

3. The ground bracket recited in claim 2, wherein the pressing device is a screw, the first and second wing portions having aligned holes therein to receive the screw so as to squeeze the first and second wing portions in a direction towards each other.

4. The ground bracket according to claim 3, wherein the screw has a head and the hole in the second wing portion is threaded, the screw being inserted through the aligned holes in the first wing portion and threadingly engaged with the threaded hole in the second wing portion with the head engaging the first wing portion.

5. The ground bracket recited in claim 2, wherein the pressing device is a rivet, the first and second wing portions having aligned holes therein to receive the rivet so as to squeeze the first and second wing portions in a direction towards each other.

6. The ground bracket recited in claim 2, wherein the pressing device is a bolt and nut, the first and second wing portions having aligned holes therein to receive the bolt, the nut being threadable to the end of the bolt to squeeze the first and second wing portions in a direction towards each other as the nut is tightened.

7. The ground bracket recited in claim 6, wherein the nut has a head and is inserted through the aligned holes in the first and second wing portions with the head against the first wing portion, the nut threadingly coupling the bolt and engaging against the second wing portion.

8. The ground bracket recited in any preceding claim, further comprising a conductive pad placed between the first wing portion and the filter.

9. The grounding bracket according to claim 1, wherein the means for pressing the first and second wing portions together comprises forming the first and second wing portions from a resiliently flexible material configured such that the distance between the first and second wing portions is less than the distance between the first and second wing portions when the first and second wing portions have been elastically deformed to receive a display apparatus therebetween, so as to bias the first and second wing portions against the filter and the chassis, respectively.

10. The grounding bracket of any preceding claim , wherein the ground bracket is formed of a material that includes a conductive material.

11. A display apparatus having a grounding bracket according to any preceding claim, the display apparatus comprising:
a display panel which displays an image;
a filter which includes an electromagnetic shielding layer and is directly attached to a first surface in which the image of the display panel is formed;
a chassis, which is disposed on the side of a second surface, which is an opposite surface of the first surface, of the display panel and supports the display panel;
the first wing portion of the grounding bracket being electrically connected to the electromagnetic shielding layer of the filter and the second wing portion being electrically connected to the chassis, the first and second wing portions being pressed towards each other by said means.

12. The display apparatus of claim 1, wherein the chassis includes a conductive material.
